# DEMANDE DE BREVET EUROPEEN

(11) **EP 2 009 136 A2**
(43) Date de publication de la demande: **31.12.2008**
(21) Numéro de dépôt: 08156862.8
(22) Date de dépôt: 23.05.2008
(51) Int. Cl.: C23C 16/40, C23C 16/452, C03C 17/245, C23C 16/04

(54) **Procédé de fabrication d'élément optique en silice ou en verre**

(30) Priorité: 04.06.2007 FR 0755445
(71) Demandeur: Commissariat A L'Energie Atomique - CEA, 75015 Paris (FR)
(72) Inventeur: Ravel, Guillaume, 38000 Grenoble (FR)
(74) Mandataire: Ilgart, Jean-Christophe

(57) **Abrégé**

L'invention concerne un procédé de fabrication d'élément optique en silice, caractérisé en ce qu'il comprend au moins une étape de dépôt de silice sur au moins une face de l'élément optique.

L'invention s'applique plus particulièrement à la fabrication de lames de phase.

## Description

### Domaine technique et art antérieur

L'invention concerne un procédé de fabrication d'élément optique en silice ou en verre.

Les méthodes traditionnelles de fabrication d'éléments de microoptique, tels que les microlentilles de profil arbitraire, les réseaux, les lames et masques de phase se regroupent en différentes techniques, à savoir :
- l'écriture laser directe,
- la gravure par usinage ionique réactif, associée à la photolithographie,
- l'injection de plastiques dans des moules,
- l'embossage sous ultra-violet.

Lorsque les objets à fabriquer sont faits de silice ou de verre, pour des applications de haute technologie (telles que les lames de phase utilisées pour corriger les faisceaux de lasers de puissance), seules les techniques d'écriture laser et de photolithographie sont utilisées.

Des améliorations de ces deux techniques ont été développées. Ainsi, le re-fluage de la résine de masquage permet-il d'obtenir le transfert d'un profil non abrupt dans la silice lors de l'étape de gravure. La finesse de gravure peut également être améliorée en utilisant des techniques d'insolation de la résine mettant en jeu un mécanisme d'interférences (technique dite de lithographie interférométrique). Des techniques avancées de lithographie par faisceau d'électrons peuvent également être mises en oeuvre.

Toutes ces techniques basées sur la photolithographie intègrent en fait une étape de gravure, c'est-à-dire une étape durant laquelle de la matière est enlevée.

En ce qui concerne les techniques basées sur l'écriture laser directe, soit elles procèdent par structuration de la résine et impliquent en conséquence une étape ultérieure de gravure utilisant la résine structurée comme masque, soit elles procèdent par interaction directe avec le matériau et on parle alors d'ablation laser car le matériau est directement éliminé de la zone de la surface balayée par le faisceau laser. Il s'agit donc encore ici de technique reposant sur l'enlèvement de matière.

Les procédés connus de fabrication et d'usinage d'éléments en silice ou en verre comprennent donc tous des étapes durant lesquelles de la matière est enlevée, nécessitant alors l'intervention de nombreux outillages et/ou de nombreux produits différents (laser, source UV, pompe à vide, solvants, résines de masquage, etc.). L'invention ne présente pas cet inconvénient.

### Exposé de l'invention

En effet, l'invention concerne un procédé de fabrication d'élément optique, caractérisé en ce qu'il comprend au moins une étape de dépôt de silice sur au moins une face d'un substrat optique en silice ou en verre.

La silice déposée sur la face du substrat optique est formée par la succession d'étapes élémentaires suivantes :
- formation, à partir d'un gaz, d'espèces excitées ou instables dans une enceinte dont les parois forment deux électrodes entre lesquelles est appliquée une haute tension,
- évacuation des espèces excitées ou instables formées dans l'enceinte dans une zone de post-décharge dans laquelle est introduit un gaz précurseur contenant des molécules de silice,
- formation, dans la zone de post-décharge, de molécules de silice suite à l'interaction du gaz précurseur avec les espèces excitées ou instables,
- conduction des molécules de silice formées dans la zone de post-décharge jusque sur la face du substrat optique à l'aide d'un capillaire.

De façon préférentielle, la formation d'espèces excitées ou instables dans une enceinte s'effectue à la pression atmosphérique.

Selon un perfectionnement du procédé de l'invention, le capillaire est déplacé au dessus de la face du substrat optique.

Le procédé de l'invention s'applique avantageusement à la fabrication des lames de phase.

Basé sur une technique de dépôt localisé de silice, le procédé de l'invention permet avantageusement la réalisation directe des profils de silice recherchés par une addition contrôlée de la silice.

### Brève description des figures

D'autres caractéristiques et avantages de l'invention apparaîtront à la lecture d'un mode de réalisation préférentiel de l'invention fait en référence aux figures jointes, parmi lesquelles :
- la figure 1 représente un schéma de principe de dispositif pour la mise en oeuvre du procédé de l'invention ;
- la figure 2 illustre, par une photographie, un exemple de motifs obtenus par le procédé de l'invention.

### Description détaillée d'un mode de réalisation préférentiel de l'invention

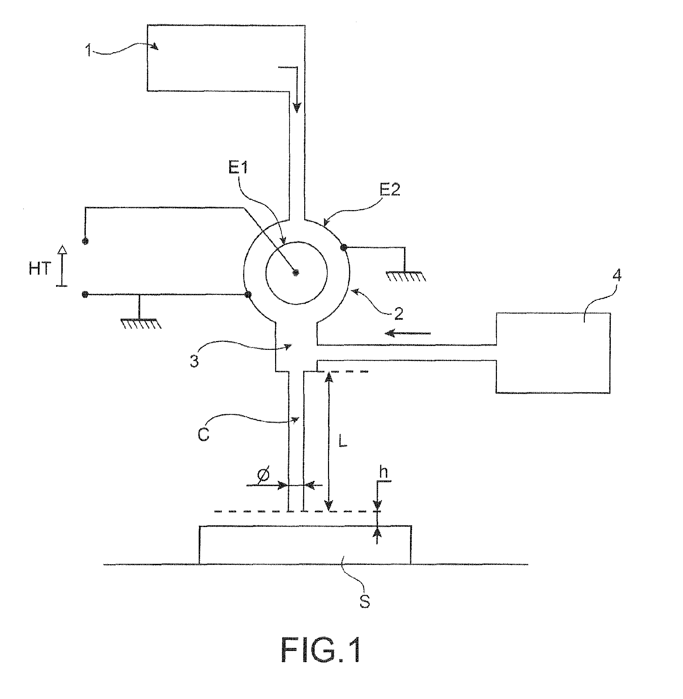

La figure 1 représente un schéma de principe de dispositif pour la mise en oeuvre du procédé de l'invention.

Le dispositif comprend une source de gaz 1, une enceinte 2 de formation d'espèces excitées ou instables, une cavité de post-décharge 3, une source de gaz précurseur 4 et un capillaire C. L'enceinte 2 de formation d'espèces excitées ou instables comprend deux électrodes E1 et E2 entre lesquelles une haute tension HT est appliquée, haute tension dont la valeur varie, par exemple, de quelques centaines de volts à quelques milliers de volts. La source de gaz 1 contient un gaz ou un mélange de gaz tel que, par exemple, l'azote (N₂), l'oxygène (O₂), un mélange d'azote et d'oxygène, l'air. Lorsque le gaz ou le mélange de gaz provenant de la source de gaz 1 pénètre dans l'enceinte 2, il y a formation d'espèces gazeuses excitées ou instables. Les espèces excitées ou instables qui sont formées dans l'enceinte 2 pénètrent ensuite dans la cavité de post-décharge 3. La cavité de post-décharge 3 est une zone de confinement où les réactions chimiques sont facilitées. Le gaz précurseur, par exemple de l' hexaméthyldisilane ((Si-(CH₃)₃)₂), de l'hexaméthyldisiloxane ((CH₃)₃-Si-O-Si-(CH₃)₃) ou de l'hexaméthyldisilazane ((CH₃)₃-Si-N-Si- (CH₃)₃), qui provient de la source 4 et qui pénètre dans la cavité 3 permet alors la formation de molécules de silice. Le capillaire C conduit les molécules de silice jusqu'à la surface d'un substrat optique S (en silice ou en verre) où elles se déposent. La distance h qui sépare le capillaire C du substrat S est comprise, par exemple, entre 5 et 20 mm. De façon connue en soi, l'épaisseur de silice déposée est contrôlée à l'aide de paramètres de contrôle communément utilisés dans les dispositifs plasmagènes (puissance de la source électrique, débits des gaz, etc.). La vitesse de dépôt est comprise, par exemple, entre 1nm et 10nm par minute.

Dans un mode de réalisation particulièrement avantageux de l'invention, le capillaire est mû par un robot (non représenté sur la figure) de telle sorte que le capillaire peut décrire la totalité de la surface du substrat. Un dispositif optique de mesure d'épaisseur de dépôt embarqué sur le robot, par exemple un dispositif d'interférométrie optique, permet de mesurer l'épaisseur locale de silice en train d'être déposée. La mesure de l'épaisseur de dépôt participe alors au contrôle du dépôt. La présence d'un robot pour déplacer le capillaire permet avantageusement que le dépôt de silice puisse être effectué sans interruption, voire simultanément, sur les deux faces opposées d'un même substrat S.

Le procédé de fabrication d'élément optique de l'invention conduit à réaliser des profils de l'élément optique dans un temps considérablement plus court que le temps nécessaire par les techniques de gravure de l'art antérieur qui imposent très souvent plusieurs étapes de reprises pour atteindre le but recherché.

Un autre avantage de l'invention est l'absence d'étapes de nettoyage post-gravure, lesquelles étapes sont susceptibles de laisser des résidus à la surface du substrat. Il est alors possible d'envisager des applications où la pièce réalisée est traversée par un flux laser important telles que, par exemple, les optiques de correction de front d'onde pour les cavités laser de puissance.

Encore un autre avantage de l'invention est l'absence de limitation de la taille de la surface du substrat à traiter.

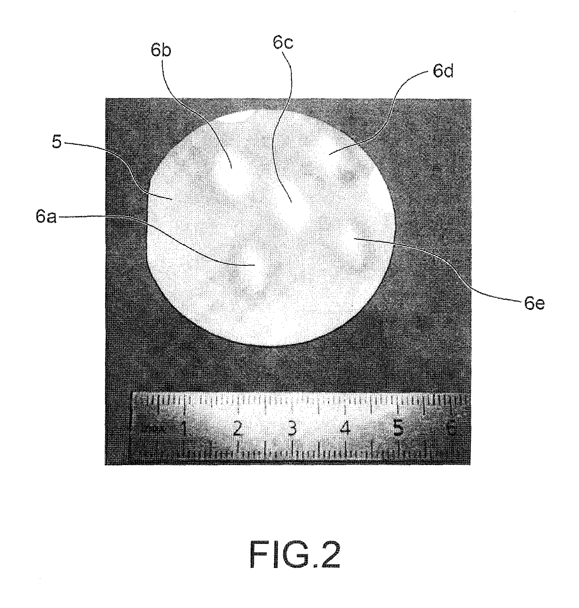

La figure 2 illustre, par une photographie, un exemple de motifs obtenus par le procédé de l'invention. Une structure 5 comprend un ensemble de cinq motifs de forme elliptique 6a-6e. Une échelle en centimètres est représentée sur cette photographie pour permettre d'évaluer la dimension des motifs. La hauteur des motifs est sensiblement égale à 100 nm. L'indice optique obtenu pour cette structure est de 1,45 pour une longueur d'onde de 600nm.

## Revendications

1. Procédé de fabrication d'élément optique, **caractérisé en ce qu'**il comprend la succession d'étapes élémentaires suivantes :
- formation, à partir d'un gaz, d'espèces excitées ou instables dans une enceinte (2) dont les parois forment deux électrodes (E1, E2) entre lesquelles est appliquée une haute tension (HT),
- évacuation des espèces excitées ou instables formées dans l'enceinte (2) dans une zone de post-décharge (3) dans laquelle est introduite un gaz précurseur contenant des molécules de silice,
- formation, dans la zone de post-décharge (3), de molécules de silice suite à l'interaction du gaz précurseur avec les espèces excitées ou instables,
- conduction des molécules de silice formées dans la zone de post-décharge (3) jusque sur la face d'un substrat optique en silice ou en verre (S) à l'aide d'un capillaire (C), et
- dépôt, sur le substrat optique (S), des molécules de silice conduites jusque sur la face du substrat optique, pour constituer l'élément optique.

2. Procédé selon la revendication 1, dans lequel la formation d'espèces excitées ou instables dans une enceinte s'effectue à la pression atmosphérique.

3. Procédé selon l'une des revendications 1 ou 2, dans lequel le gaz à partir duquel sont formées les espèces excitées ou instables est choisi parmi l'azote (N₂), l'oxygène (O₂), un mélange d'azote et d'oxygène, l'air.

4. Procédé selon l'une quelconque des revendications 1 à 3, dans lequel le gaz précurseur est de l'hexaméthyldisilane ((Si-(CH₃)₃)₂), de l'hexaméthyldisiloxane ((CH₃)₃-Si-O-Si-(CH₃)₃) ou de l'hexaméthyldisilazane ((CH₃)₃-Si-N-Si-(CH₃)₃).

5. Procédé selon l'une quelconque des revendications 1 à 4, dans lequel le capillaire (C) est déplacé au dessus de la face du substrat optique.

6. Procédé selon l'une quelconque des revendications précédentes, dans lequel l'épaisseur du dépôt des molécules de silice est contrôlée par un dispositif optique.

7. Procédé selon l'une quelconque des revendications précédentes, dans lequel l'élément optique est une lame de phase.
